## Europäisches Patentamt
## European Patent Office
## Office européen des brevets

(19)

(11) Numéro de publication: **0 064 918**
**B1**

(12) **FASCICULE DE BREVET EUROPEEN**

(45) Date de publication du fascicule du brevet:
**13.11.85**

(21) Numéro de dépôt: **82400783.5**

(22) Date de dépôt: **29.04.82**

(51) Int. Cl.⁴: **H 01 L 31/02, H 01 L 31/10**

(54) **Détecteur de rayonnement à photodiodes mesa.**

(30) Priorité: **12.05.81 FR 8109430**

(43) Date de publication de la demande:
**17.11.82 Bulletin 82/46**

(45) Mention de la délivrance du brevet:
**13.11.85 Bulletin 85/46**

(84) Etats contractants désignés:
**DE GB NL**

(56) Documents cités:
**APPLIED PHYSICS LETTERS, vol. 32, no. 1, janvier 1978, pages 65-67, New York, USA H. HOLLOWAY et al.: "IV-VI Semi-conductor lateral-collection photodiodes"**
**JOURNAL OF APPLIED PHYSICS, vol. 49, no. 8, août 1978, pages 4607-4608, New York, USA M.ITO et al.: "Ionization rates for electrons and holes in GaAs"**

(73) Titulaire: **THOMSON-CSF, 173, Boulevard Haussmann, F-75379 Paris Cedex 08 (FR)**

(72) Inventeur: **Rebondy, Jacques, THOMSON-CSF SCPI 173, bld Haussmann, F-75379 Paris Cedex 08 (FR)**
Inventeur: **Villard, Michel, THOMSON-CSF SCPI 173, bld Haussmann, F-75379 Paris Cedex 08 (FR)**

(74) Mandataire: **Mayeux, Michèle et al, THOMSON-CSF SCPI 173, Bld Haussmann, F-75379 Paris Cedex 08 (FR)**

BUNDESDRUCKEREI BERLIN

## Description

L'invention concerne un détecteur de rayonnement comportant au moins une photodiode de type mesa.

De tels détecteurs sont utilisés en imagerie, en rayonnement X ou gamma dans le domaine médical, et en rayonnement infra-rouge dans des domaines divers.

Dans tous les cas, le rayonnement incident est absorbé par la diode, dans laquelle il engendre des porteurs libres, porteurs du signal incident. Il est généralement admis que la surface sensible de la diode est à peu de chose près celle de sa jonction et, plus exactement, celle de la partie de celle-ci non occultée par l'électrode de contact et effectivement atteinte par le rayonnement, sa surface électrique étant celle de la jonction dans sa totalité.

Il est bien connu que, toutes choses étant égales par ailleurs, on a intérêt à réduire le plus possible la surface électrique, et ceci pour deux raisons principales, qui sont qu'à une grande surface de jonction correspondent:

— une résistance de la diode faible et, par voie de conséquence, un bruit thermique élevé limitant les performances de la diode;
— une capacité élevée, qui limite la fréquence maximale de fonctionnement possible.

D'une façon générale, en termes d'impédance, cela signifie que plus l'impédance de la diode est faible, plus, toutes choses égales par ailleurs, l'amplificateur qui la suit doit être doué de caractéristiques élevées, et plus le couplage entre l'un et l'autre est difficile à réaliser.

L'invention se propose de réduire de façon importante la surface électrique des photodiodes des détecteurs de rayonnement, sans changer leur surface sensible, ni réduire leur signal.

Elle utilise à cette fin le phénomène de collection latérale. Elle concerne le cas de photodiodes du type »mesa« car pour les détecteurs à diode »planar«, on a, de longue date, utilisé avec succès le même phénomène pour obtenir cette réduction, une structure planar se prêtant bien à la réalisation d'un grand nombre de petites diodes élémentaires, reliées entre elles, auxquelles correspond une grande surface sensible avec une surface électrique réduite. On sait que l'inconvénient de ces systèmes »planar« vient de ce que leur technologie, dans l'ensemble, est plus difficile et que, d'autre part, pour profiter à plein du phénomène il faut adopter une structure inversée, où le détecteur est éclairé par sa face opposée à celle sur laquelle sont formées les jonctions, obtenues par des diffusions; ceci entraîne la nécessité d'un substrat transparent à ce rayonnement et le risque de recombinaisons aux interfaces. Dans l'invention l'éclairage à lieu par la face avant des diodes.

Des structures »planar« a éclairage par la face arrière ont été mentionnées par Holloway dans l'article »Theory of lateral-collection photodiodes« J. Appl. Phys. 49 (7), Juli 1978.

Le brevet américain 4 021 836 décrit lui, des structures »mesa« éclairées en face arrière.

L'invention concerne donc un détecteur comportant au moins une photodiode »mesa« éclairée par l'avant, avec collection latérale conformément à la revendication 1.

Elle sera mieux comprise en se reportant à la description qui suit et aux figures jointes qui représentent:

— figures 1(a) et 1(b): des vues en coupe et en plan d'une diode »mesa«;
— figure 2: une vue montrant en perspective la disposition adoptée pour une diode »mesa« de l'invention;
— figure 3(a, b, c): des vues en perspective de l'une des couches de la diode mesa de l'invention;
— figure 4: une variante de la figure 2.

La figure 1(a) montre en coupe une diode »mesa«.

Une jonction 1 est réalisée entre une couche d'entrée 2 du type n, transparente au rayonnement incident, représenté par l'ensemble des flèches ondulées, sur lesquelles on reviendra, et une couche 3 absorbante pour le rayonnement incident, de type p. Les deux couches sont par exemple obtenus par épitaxie sur un substrat 4; l'ensemble est recouvert, généralement d'une couche protectrice mince 5 en un matériau diélectrique; les contacts sur les zones n et p, représentés en 6 et 7 consistent en des dépôts conducteurs en contact avec les couches 2 et 3 par des fenêtres prévues dans le diélectrique. Comme on le voit sur la figure, la structure »mesa« est caractérisée par l'existence d'une dépression tout autor de la surface de la diode. Cete dépression est obtenue par gravure jusqu'à une profondeur dépassant la couche 1. La jonction se touve ainsi délimitée par la gravure, et la diode, en relief par rapport au reste de la surface, séparée de ses voisines.

Quant au phénomène de collection latérale, il est mis en évidence par trois flèches repérées 8, 9, 10: pour un rayonnement arrivant suivant la flèche 8, les porteurs libres créés par absorption de ce rayonnement sont immédiatement collectés par la jonction; ceux crées en 9 le sont après un trajet relativement court (flèche en trait plein), tandis que ceux correspondant au rayon 10 gagnent cette jonction après un trajet oblique plus long, suivant la flèche en traits interrompus; pour ces derniers il y a collection latérale.

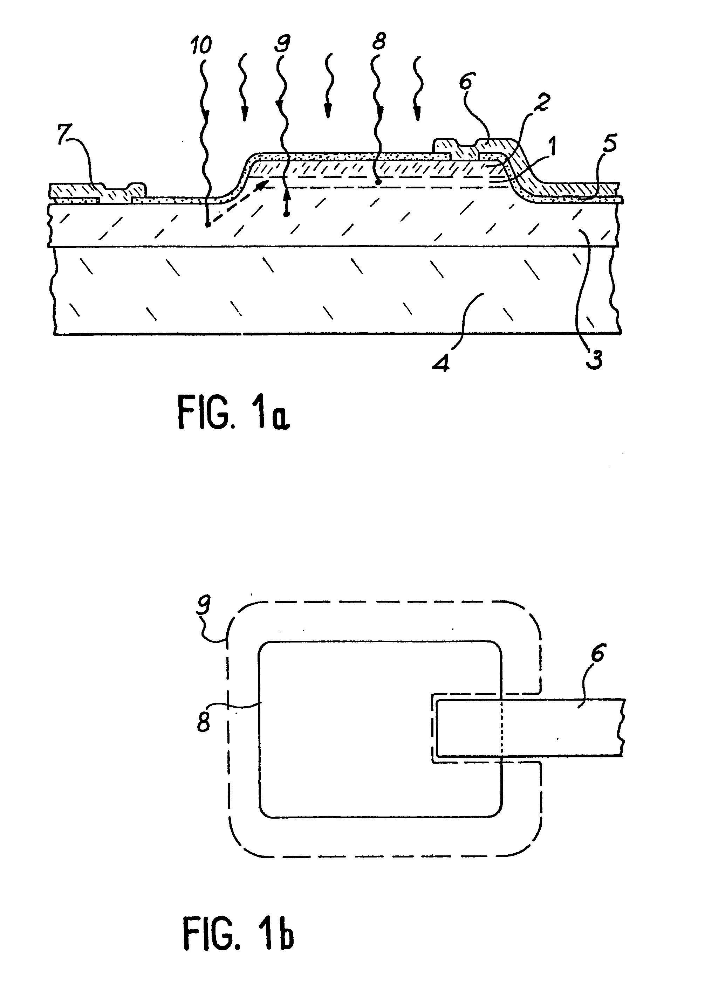

La figure 1(b) représente la même diode vue en plan de dessus; sur cette figure, la surface électrique est limitée au rectangle 8 correspondant à l'étendue de la jonction; on a choisi d'autre part le repère 9 de la figure précédente pour limiter, dans son ensemble, la surface sensible à mi-signal où il y a collection après un trajet en dehors de la jonction elle-même, et notamment collection latérale.

Pour diminuer la surface électrique, l'invention prévoit de ménager des trous dans la couche 2 exposée au rayonnement. Chaque diode »mesa« se trouve aini divisée en un grand nombre de petites diodes élémentaires reliées entre elles, ce qui correspond à une grande surface sensible et une faible surface électrique, considérablement réduite par rapport à celle de la diode initiale. Pour chacune de ces diodes élémentaires on se trouve placé dans des conditions de collection favorables compte tenu du phénomène de collection latérale.

On notera, au passage, que la même disposition, appliquée à une structure »planar«, où la jonction est réalisée par une diffusion dans le matériau absorbant la lumière ne donnerait aucun résultat, car l'existence des trous que l'on pourrait réaliser dans les diodes ne ferait qu'augmenter la surface électrique de celles-ci.

Selon l'invention, la couche supérieure de la diode exposée au rayonnement est percée de trous jusqu'au-délà de la jonction. Les dimensions des trous sont choisies de façon telle que le plus long chemin que les porteurs libres engendrés par le rayonnement incident aient à parcourir dans le matériau absorbant, avant d'être collectés par la jonction, soit inférieur à la longueur de diffusion de ces porteurs dans ce matériau.

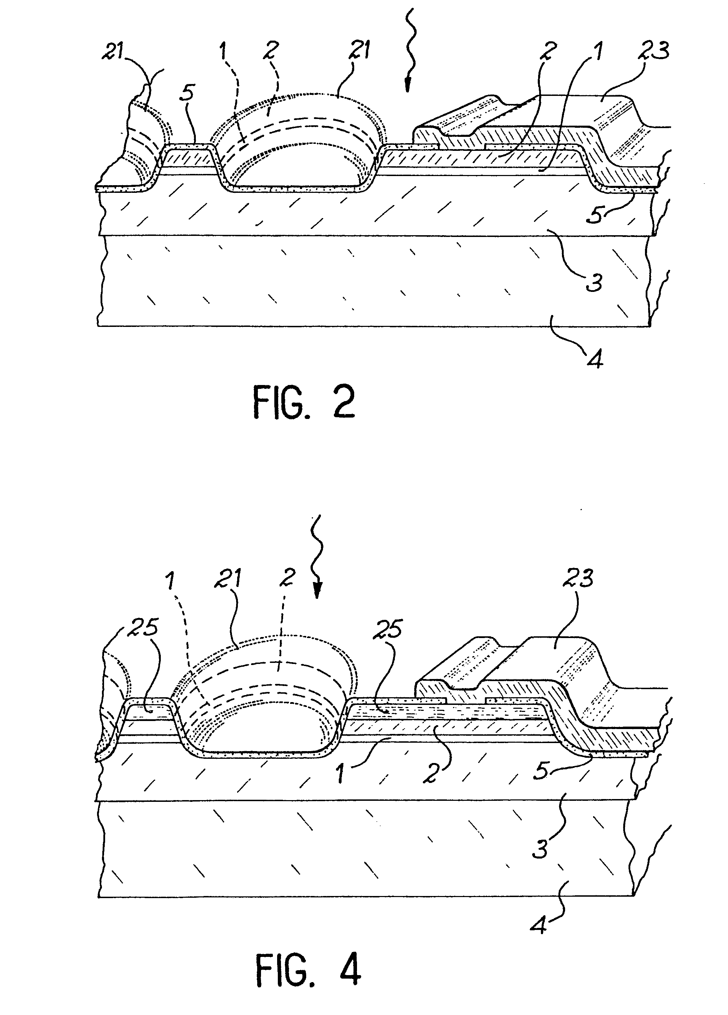

Sur la figure 2 on a rprésenté une coupe d'une partie du détecteur de l'invention, montrant comment se présenteraient ses différents éléments dans une perspective au-delà du plan de la coupe de la figure 1(a), après la préparation de la couche supérieure 2. Cette couche est percée de trous dont un seul est représenté en entier sur la figure, avec le repère 21; ces trous sont obtenus notamment par gravure chimique de la couche 2, jusqu'à une profondeur dépassant le niveau de la jonction 1, comme on le voit sur la figure, où la couche 3 apparaît sur la paroi du trou 21 (paroi sur laquelle on a rajouté les repères de la partie droite de la figure), au-dessus de la couche isolante 5. Le contact collectif des diodes élémentaires porte le repère 23 sur cette figure, où tous les autres repères sont les mêmes que sur les figures 1(a) et 1(b).

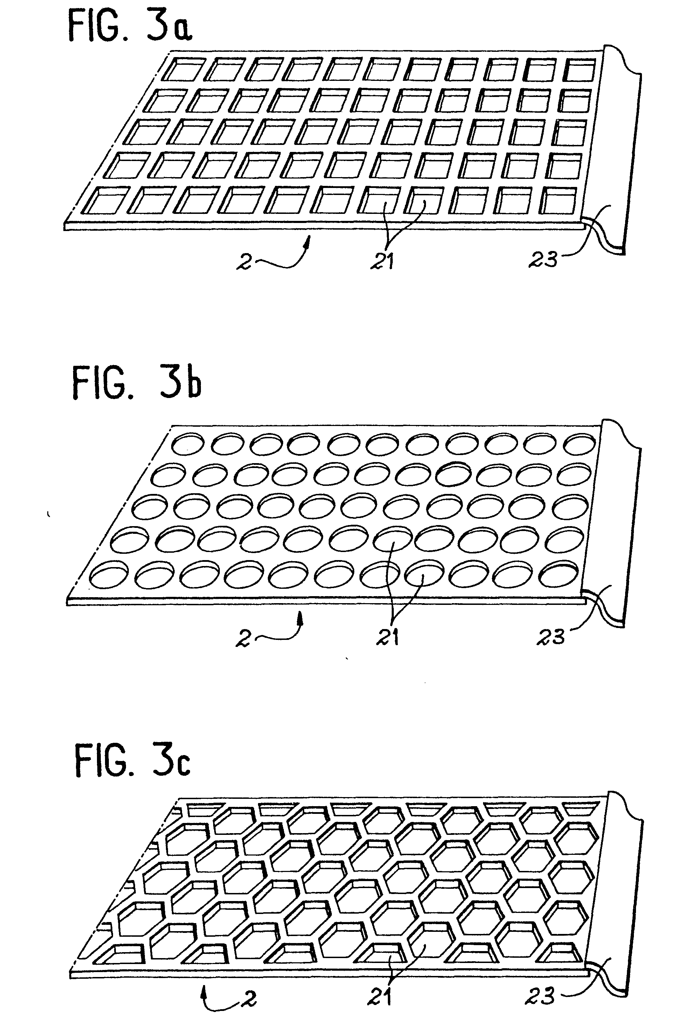

On a représenté, par ailleurs, sur la figure 3, une partie de la couche 2 d'une diode »mesa« du détecteur de l'invention, avec son contact 23, en admettant qu'elle ait été extraite de son contexte, c'est-à-dire isolée des autres éléments constitutifs de la diode; on notera, à ce propos que la couche sous-jacente 3 présenterait des dépressions vis-à-vis de ces trous, comme il ressort de la coupe de la figure 2. Cette représentation a été faite dans le cas de trois variantes à trous ronds, rectangulaires et en nid d'abeilles, étant entendu que sont également comprises dans l'invention toutes autres dispositions à trous de formes différentes.

Dans un exemple, on a réalisé des trous ronds de 10 micromètres de diamètre écartés de 0,5 micromètre dans une couche 2 de 2 mm × 2 mm.

La collection des porteurs libres est pratiquement complète lorsque la plus grande dimension des trous est inférieure à la longueur de diffusion dans le matériau absorbant de la couche 3. Cette disposition et celle recherchée lorsque l'on veut conserver l'intégralité du signal. La photodiode de l'invention est alors pratiquement équivalente sur le plan optique à la photodiode sans trous de l'art antérieur (figure 1(a)), tandis que la surface électrique est sensiblement plus réduite; sa capacité électrique est couramment divisée par 10. Un tel gain a été obtenu, dans un exemple, avec des trous carrés de 10 micromètres de côté éspacés de 0,5 micromètre, réalisés dans une couche 2 en tellurure de plomb, PbTe, déposée sur une couche 3 en tellurure d'étain plomb, PbSnTe.

Avec des matériaux à grande longueur de diffusion, comme de tellurure de cadmium mercure, HgCdTe, ou l'antimoniure d'indium, InSb, la réduction de capacité peut être encore plus importante; elle peut atteindre des valeurs allant jusqu'à 35, avec des trous, cette fois, de dimensions plus importantes, par exemple des carrés de 70 micromètres de côté, espacés de 1 micromètre, et ceci pratiquement sans perte de signal.

La disposition de l'invention se prête à la réalisation d'un contact de collection réparti, dans les conditions qui vont être précisées.

La figure 4 montre la réalisation d'un tel contact. La différence entre la structure de cette figure et celle de la figure 2, consiste dans l'existence d'un niveau supplémentaire 25, dont le rôle est d'assurer une liaison électrique entre les lieux de création des porteurs libres et l'électrode de connexion 23, notamment lorsque la résistance de couche du matériau de la couche 2 est du même ordre que la résistance de la jonction de la diode. En l'absence de contact réparti, avec la seule collection par l'électrode 23, le courant risquerait de se reboucler partiellement dans la jonction.

Ce niveau 25 consiste en une électrode de contact réalisée en un matériau conducteur de l'électricité recouvrant, comme le montre le dessin, la couche 2. Si un métal est employé à cette fin, son épaisseur doit être suffisamment faible pour qu'il soit transparent aux rayons incidents; une coche d'or ou d'aluminium de 20 nm d'épaisseur satisfait à cette condition. On peut aussi utiliser un matériau fortement dopé, non absorbant.

La technique du contact réparti est particulièrement interessante dans le cas de photodiodes à grande surface, comme dans les auto directeurs infrarouge à quatre quadrants.

Le detecteur selon l'invention peut être utilisé dans toutes les applications habituelles des détecteurs à l'état solide, détection infrarouge, nucléaire, imagerie médicale.

## Revendications

1. Détecteur de rayonnement comportant au moins une photodiode de type mesa (1, 2, 3) formée sur un substrat (4), soumis au rayonnement incident par sa face opposée à ce substrat, caractérisé en ce que ladite photodiode est percée, sur sa face exposée au rayonnement, d'une mosaïque de trous (21) s'étendant en profondeur jusqu'au delà de sa jonction (1).

2. Détecteur de rayonnement suivant la revendication 1, caractérisé en ce que la plus grande dimension des trous (21) est inférieure à la longueur de diffusion des porteurs libres créés en fonctionnement dans la couche de la diode sous-jacente à la jonction.

3. Détecteur de rayonnement suivant la revendication 1, caractérisé en ce que la photodiode (1, 2, 3) comporte en outre, la recouvrant entre les trous, sur sa face exposée au rayonnement, une couche (25) d'un matériau conducteur de l'électricité, transparente au rayonnement incident, reliée électriquement au contact (23) de cette face de la photodiode.

## Patentansprüche

1. Strahlungsdetektor mit wenigstens einer Photodiode vom Mesatyp (1, 2, 3), die auf einem Substrat (4) gebildet ist und der einfallenden Strahlung auf ihrer dem Substrat gegenüberliegenden Fläche ausgesetzt ist, dadurch gekennzeichnet, daß die genannte Photodiode auf ihrer der Strahlung ausgesetzten Fläche von einem Löchermosaik (21) durchbrochen ist, welches sich in die Tiefe bis jenseits ihres Übergangs (1) erstreckt.

2. Strahlungsdetektor nach Anspruch 1, dadurch gekennzeichnet, daß die größere Abmessung der Löcher (21) kleiner als die Diffusionslänge der freien Ladungsträger ist, die im Betrieb in der Schicht der Diode, welche unter dem Übergang liegt, erzeugt werden.

3. Strahlungsdetektor nach Anspruch 1, dadurch gekennzeichnet, daß die Photodiode (1, 2, 3) ferner auf ihrer der Strahlung ausgesetzten Fläche eine sie zwischen den Löchern bedeckende Schicht (25) aus einem elektrisch leitfähigen Material aufweist, die für die einfallende Strahlung durchlässig und elektrisch mit dem Kontakt (23) dieser Fläche der Photodiode verbunden ist.

## Claims

1. Radiation detector comprising at least one photodiode of mesa type (1, 2, 3) formed on a substrate (4), exposed to the incident radiation on its face opposite to this substrate, characterized in that said photodiode is pierced on its side exposed to the radiation by a pattern of holes (21) extending into the depth beyond its junction (1).

2. Radiation detector according to claim 1, characterized in that the major dimension of the holes (21) is inferior to the diffusion length of the free carriers generated, in operation, in the diode layer beneath the junction.

3. Radiation detector according to claim 1, characterized in that the photodiode (1, 2, 3) further comprises, on its face exposed to the radiation, a layer (25) of electrically conductive material covering the photodiode between the holes and which is transparent to the incident radiation as well as electrically connected to the contact (23) of this face of the photodiode.

FIG. 1a

FIG. 1b

FIG. 2

FIG. 4

# FIG. 3a

# FIG. 3b

# FIG. 3c